# EUROPÄISCHE PATENTSCHRIFT

(11) **EP 1 253 430 B1**
(45) Veröffentlichungstag und Bekanntmachung des Hinweises auf die Patenterteilung: **28.01.2004**
(21) Anmeldenummer: 02013516.6
(22) Anmeldetag: 11.02.2000
(51) Int. Cl.: G01R 31/02, G01R 31/00

(54) **Verfahren und Einrichtung zur Stromüberwachung in einem Stromversorgungssystem**
Procedure and device for current monitoring in a power distribution network
Procédé et dispositif pour surveiller le courant dans un système d'alimentation électrique

(30) Priorität: 15.02.1999 DE 19906276
(43) Veröffentlichungstag der Anmeldung: 30.10.2002
(62) Teilanmeldung aus: 00102877.8
(73) Patentinhaber: Isabellenhütte Heusler GmbH KG, D-35683 Dillenburg (DE)
(72) Erfinder: Hetzler, Ulrich, Dr., 35688 Dillenburg-Oberscheld (DE)
(74) Vertreter: Heusler, Wolfgang, Dipl.-Ing.

(56) Entgegenhaltungen:
- EP-A- 0 408 867
- DE-A- 3 942 165
- DE-A- 19 510 662
- DE-C- 19 507 959
- US-A- 4 942 571

## Beschreibung

Die Erfindung betrifft ein Verfahren zur Stromüberwachung in einem Stromversorgungssystem gemäß dem Oberbegriff des Anspruchs 1 und eine hierfür geeignete Stromüberwachungseinrichtung.

Ein typisches Beispiel für ein Stromversorgungssystem der hier betrachteten Art ist die Versorgung der mit zunehmenden Anforderungen an Komfort, Sicherheit und Umweltverträglichkeit von Jahr zu Jahr wachsenden Anzahl elektrischer Verbraucher in Kraftfahrzeugen. Für den entsprechend erhöhten Stromverbrauch erweist es sich als zweckmäßig, die verschiedenen Verbraucher ring- oder sternförmig über einen gemeinsamen Leistungsbus an eine Quelle relativ hoher Spannung von beispielsweise 42V anzuschließen, die niedrigere Ströme als bei den bisher üblichen 12V-Batterien und entsprechend kleinen Leitungsquerschnitt ermöglicht. Wenn man beispielsweise einen Gesamtverbrauch von bis zu 5 kW annimmt, ergibt sich bei 42V ein maximaler Gesamtstrom von 120 A, der in Fahrzeugen noch gut zu beherrschen ist. Die Quelle hoher Spannung kann zusätzlich zu einem Bordnetz niedrigerer,Spannung vorgesehen sein.

Für den Steuer- und Informationsdatenaustausch zwischen den ebenfalls immer zahlreicher werdenden verschiedenen Prozessoren, Aktoren und Sensoren von Fahrzeugen u.a. für Motorsteuerung und Komfort-Elektronik (Fensterheber, automatische Sitzverstellung, Klimaregelung usw.) hat sich bereits weitgehend die Verwendung von genormten Datenbussystemen (beispielsweise des sogenannten CAN-Bus) durchgesetzt, die parallel zu dem Leistungsbus angeordnet werden können. Auch für die benötigten Halbleiter ist ein Stromversorgungsnetz mit höheren Spannungen wie z.B. 42V vorteilhaft, da aus verschiedenen Gründen die für das sichere Schalten eines Verbrauchers benötigte Halbleiterfläche wesentlich geringer ist als im Falle eines 12V-Bordnetzes.

Mit zunehmender Anzahl der Verbraucher und steigender Gesamtleistung wächst aber andererseits die Gefahr von Störungen und insbesondere von Kurzschlüssen, deren Folgen katastrophal für Sicherheit und Funktion des Fahrzeugs sein können. Besonders groß ist die Brandgefahr. Entsprechend groß war bisher der erforderliche Sicherheits- und Funktionsprüfaufwand unter Verwendung von Sicherungen und Strommesselementen, die typisch den einzelnen Verbrauchern individuell zugeordnet wurden.

Aus der DE 195 07 959 C ist eine Vorrichtung zur Strommessung an einer der Hauptstromleitungen einer Fahrzeugbatterie bekannt, bei der ein Spannungsabfall an einem Messwiderstand in der zu messenden Hauptstromleitung von einem externen Prüfgerät erfasst und ausgewertet wird. Das externe Prüfgerät vergleicht den bei Aktivierung der einzelnen Verbraucher gemessenen Batteriestrom mit gespeicherten Sollwerten. Als Messwiderstand dient ein über eine zusätzliche Prüfleitung kalibrierter Abschnitt der Hauptstromleitung, wodurch sich die Notwendigkeit erübrigen soll, einen Präzisionsmesswiderstand einzusetzen.

Auch aus der EP 0408867 A ist ein externes Testsystem für die Verbraucher eines Kraftfahrzeugs bekannt, bei dem nach Aktivierung des jeweils zu testenden Verbrauchers dessen Strom in der externen Diagnoseeinheit mit einem verbraucherspezifischen Sollwert verglichen wird. Als Messwiderstand wird hierbei ein externer Shunt zwischen die Fahrzeugbatterie und den Verbraucher geschaltet.

Die DE 39 42 165 A beschreibt ein System zur Stromüberwachung in einem Kraftfahrzeug, bei dem mehrere parallel zueinander an einen von der Batterie gespeisten Leistungsbus angeschlossene Stellelemente mit Strom versorgt werden. Zwischen den Leistungsbus und jedes Stellelement ist ein magnetischer Stromsensor geschaltet, mit dem der in die jeweilige Betriebsschaltung der Stellelemente fließende Strom erfasst wird. Bei der Feststellung von Fehlern wird zur Ausschaltung von Messfehlern aufgrund der Offsetspannung des magnetischen Sensors der in die Betriebsschaltung fließende Strom zunächst vor Anlegen eines Steuersignals zur Betätigung des betreffenden Stellelementes erfaßt und dann nach einer vorbestimmten Zeit nach Anlegen dieses Steuersignals nochmals gemessen. Aus der Differenz der gemessenen Stromwerte kann dann ermittelt werden, ob ein Funktionsfehler des entsprechenden Stellgliedes vorliegt.

Die US 4,942,571 beschreibt ein in ein Kraftfahrzeug eingebautes Multiplex-Überwachungssystem, bei dem ebenfalls jedem Verbraucher eigene Sensoren zugeordnet sind.

Aus der DE 19510662 A ist ein aktives optisches Strommesssystem für die isolierte Strommessung in Hochspannungsstromrichtern bekannt, bei dem die Sensorelektronik in einem Hohlraum im Inneren eines zweiteiligen Präzisionsmesswiderstands untergebracht und ausgangsseitig mit einem Lichtwellenleiteranschluss verknüpft ist. Diese Anordnung dient dem mechanischen Schutz und der elektromagnetischen Abschirmung der Sensorelektronik.

Der Erfindung liegt die Aufgabe zugrunde, ein Verfahren bzw. eine Stromüberwachungseinrichtung anzugeben, die auf einfache Weise mit geringerem Aufwand als bisher eine schnelle und möglichst genaue Stromüberwachung im Stromversorgungssystem beispielsweise eines Fahrzeugs mit zahlreichen Verbrauchern ermöglicht.

Diese Aufgabe wird durch die kennzeichnenden Merkmale der Patentansprüche 1 bzw. 9 gelöst.

Gemäß einem ersten Aspekt der Erfindung wird nicht jedem Verbraucher ein eigener Stromsensor zugeordnet, sondern mehreren oder sogar allen Verbrauchern ein einziger Messwiderstand in dem Leistungsbus zur permanenten Stromüberwachung vorgeschaltet. Die Stromerfassung ist schnell und genau und kann über den Steuerbus dem Zu- oder Abschalten eines Verbrauchers zeitlich exakt zugeordnet werden. Da der jeweilige Strom-Istwert über den Steuerbus jedem vorhandenen Prozessor oder sonstigen Steuerglied direkt zugänglich ist, kann das elektronische Steuer- und Überwachungssystem problemlos feststellen, ob sich bei dem betreffenden Schaltvorgang normale Stromänderungen ergeben oder nicht. Beispielsweise läßt sich über den Stromverbrauch von Aktoren deren Belastung feststellen und damit Fehl- oder Störfunktionen der betreffenden Motoren (Fensterheber, Anlasser, Lüfter u.a.) erkennen. Insbesondere die permanente Erfassung des Gesamtstroms im Fahrzeug kann zum Erkennen von Störfällen von großer Bedeutung sein. Auch der Strom eines den Leistungsbus speisenden Generators kann überwacht werden.

Da viele oder alle Verbraucher und ggf. der Generator mit einem einzigen Stromsensorwiderstand überwacht werden können, besteht die Möglichkeit, auf zahlreiche bisher notwendige Stromsensoren und Sicherheitsschaltungen wie z.B. individuelle Lampenstromerfassung, Sicherungen usw. zu verzichten. Darüber hinaus werden ganz neue Möglichkeiten der Sicherheits- und Funktionsprüfung eröffnet. Aus der Auswertung der gemessenen Stromdifferenz kann die Steuerung auch sonstige Schaltsignale für beliebige Steuervorgänge erzeugen, beispielsweise zum Abschalten einzelner nicht dringend benötigter Verbraucher wie etwa der Heckscheibenheizung bei zu hohem Gesamtstrom.

Die erfindungsgemäße Anordnung des Messwiderstands in dem Leistungsbus ermöglicht auch auf einfache Weise eine Stromsteuerung zum Schutz der den Bus und die angeschlossenen Verbraucher speisenden Batterie, insbesondere mit dem Ziel der Verlängerung ihrer Lebensdauer. Mit der Messung des durch den Bus fließenden Gesamtstroms kann man nämlich auch die Lade- und Entladeströme der Batterie überwachen und begrenzen.

Welche Überwachung im einzelnen in einem Fahrzeug vorgenommen wird, ist im wesentlichen eine Frage des vorhandenen Steuersystems und der zugehörigen Software. Die Ausführung des Messwiderstand enthaltenden Stromsensors könnte aber für alle Anwendungen identisch sein.

Der bauliche Steueraufwand kann dadurch auf ein Minimum reduziert werden, dass entsprechend der heutigen Halbleitertechnik in einem einzigen kleinen, preisgünstig herstellbaren Halbleiterchip als anwendungsspezifische integrierte Schaltung (ASIC) eine komplette Steuereinheit für den Steuerbus zusammen mit den zum Messwiderstand gehörenden Schaltungen wie Messverstärker, A/D-Wandler, Prozessor, Speichern usw. untergebracht werden können.

Für die gewünschte schnelle und.möglichst extrem genaue Stromerfassung sind von entscheidender Wichtigkeit einerseits die Messpräzision des verwendeten Messwiderstands selbst und andererseits die störungsfreie Übertragung der Messspannung des Widerstands in das Steuersystem. Hierbei kommt es neben der Vermeidung externer Störsignale vor allem auf die Unabhängigkeit von Temperatureinflüssen an.

Diese Probleme werden gemäß einem wichtigen zusätzlichen Ausführungsbeispiel der Erfindung durch ein Strommessmodul gelöst, bei dem das zu dem Widerstand gehörende Halbleiterchip unmittelbar oder über eine wärmeleitende Leiterplatte auf der Metalloberfläche des zweckmäßig plattenförmigen Widerstands und vorzugsweise in deren Mitte angeordnet ist. Neben kleinem Bauvolumen und einfacher kostengünstiger Herstellbarkeit hat dieses Strommessmodul den Vorteil extrem kurzer Verbindungen zwischen den Spannungsanschlüssen des Messwiderstands und den zugehörigen Halbleiterschaltungen mit der Folge, dass keine wesentlichen Störspannungen induziert werden können. Darüber hinaus ergeben sich aufgrund der thermischen Kopplung optimale Temperaturkompensationsmöglichkeiten. Bei dem Widerstand kann es sich zweckmäßig um ein Bauelement mit einem aus einer Widerstandslegierung bestehenden plattenförmigen Widerstandselement handeln, an dessen Kanten in an sich bekannter Weise (EP 0 605 800 B1) plattenförmige Anschlußteile angeschweißt sind. Der Widerstand läßt sich mit sehr kleinem Widerstandswert herstellen, beispielsweise in der Größenordnung von 0,1-0,5 mOhm, was entsprechend kleine Verlustleistung selbst bei erheblichen Stromstärken bedeutet, die im Falle von Fahrzeugen kurzzeitig bis 500 A betragen können.

Strommessmodule der hier beschriebenen Bauform können sowohl zur Erfassung des Gesamtstroms mehrerer oder aller Verbraucher des Systems eingesetzt als auch zur individuellen Strommessung nur in den Stromkreis einzelner Verbraucher oder einzelner Gruppen von (z.B. 2) Verbrauchern geschaltet werden.

Am Beispiel des Stromversorgungssystems eines Kraftfahrzeuges soll die Erfindung näher erläutert werden. In der Zeichnung zeigen
- Fig. 1: den prinzipiellen Aufbau des Steuer- und Leistungsbussystems mit einem Stromsensor;
- Fig. 2: verschiedene Möglichkeiten für die Anordnung von Stromsensoren zur Überwachung von Bestandteilen des Stromversorgungssystems;
- Fig. 3: verschiedene Ansichten eines für das System nach Fig. 1 geeigneten Strommessmoduls gemäß einer ersten Ausführungsform; und
- Fig. 4: Ansichten einer anderen Ausführungsform des Strommessmoduls.

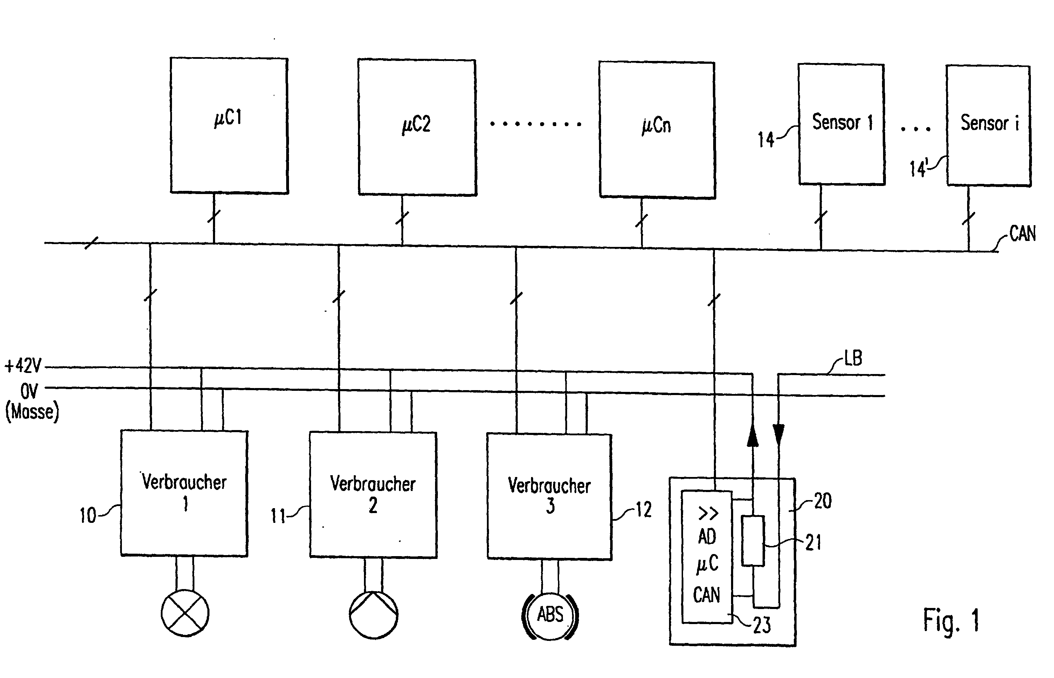

Gemäß Fig. 1 sind über einen Leistungsbus LB hintereinander drei Verbraucher 10, 11 bzw. 12 wie beispielsweise eine Glühlampe, eine Wasserpumpe bzw. ein ABS-Bremssystem mit jeweils zugehörigen Schalteinheiten an einen Stromgenerator (nicht dargestellt) angeschlossen, dessen Spannung beispielsweise 42V betragen kann. Die Schalteinheiten der Verbraucher 10 bis 12 sind ferner über Datenleitungen an einen gemeinsamen Steuerbus CAN angeschlossen, der in bekannter Weise eine Vielzahl von Mikrocontrollern (Mikroprozessoren für spezielle Steueraufgaben) µC1, µC2..µCn beispielsweise für Motormanagement, Komfortelektronik, Temperaturregelung usw. und/oder zur Steuerung der genannten Verbraucher sowie Sensoren 14, 14' etwa für Kühlwassertemperatur, Motordrehzahl usw. miteinander verbindet.

Zur Stromüberwachung der dargestellten Verbraucher 10, 11 und 12 dient ein einziges Strommessmodul 20, das im wesentlichen aus einem mit zwei Stromanschlüssen und zwei gesonderten Spannungsanschlüssen versehenen Messwiderstand 21 und einem an die Spannungsanschlüsse angeschlossenen Halbleiterchip 23 besteht. Der Messwiderstand 21 ist über seine Stromanschlüsse darstellungsgemäß elektrisch in Reihe in den Leistungsbus geschaltet, und zwar zwischen den 42V-Stromgenerator und die Verbraucher 10 bis 13, so dass deren jeweiliger Gesamtstrom durch den Messwiderstand 21 fließt. Das Halbleiterchip 23 kann einen Messverstärker, einen A/D-Wandler und einen Mikrocontroller sowie Datenspeicher enthalten und mit einem Stecker des Strommessmoduls 20 zum Anschluß an den Steuerbus CAN verbunden sein.

Wie schon erwähnt wurde, ist der Steuerbus CAN ein genormtes System, das digitale Informations- und Steuerdaten in definierter "Sprache" oder Codierung zwischen den angeschlossenen Sensoren, Prozessoren und Aktoren überträgt. Wenn einer der Verbraucher 10 bis 12 eingeschaltet werden soll, ruft die elektronische Steuerung des Systems, also beispielsweise einer der Mikrocontroller zunächst über den Steuerbus CAN aus dem Strommessmodul 20 den aktuellen Strommesswert ab und speichert ihn. Dann erfolgt die Umschaltung, und nach einer vorbestimmten kurzen Wartezeit ruft die Steuerung den sich nach dem Schaltvorgang ergebenden neuen Strommesswert ab. Die gemessene Stromdifferenz kann nun mit einem gespeicherten Sollwert oder Sollwertbereich verglichen werden, und bei unnormaler Abweichung kann ein Warnsignal erzeugt oder, falls aus Sicherheitsgründen erforderlich, auch der Strom abgeschaltet werden.

Generell kann es zweckmäßig sein, den Wert des kontinuierlich gemessenen Stroms über den Steuerbus CAN permanent möglichst vielen Controllern oder Prozessoren des Steuersystems zur Verfügung zu stellen. Die Auswertung dieser Strommessung und daraus resultierende Schaltmaßnahmen bleiben dem jeweiligen Einzelfall überlassen.

Es ist auch denkbar, die Auswertung der Strommessung in dem eigenen Halbleiterchip 23 des Strommessmoduls 20 durchzuführen und nur die ggf. resultierenden Schaltsteuersignale dem Steuerbus CAN oder einem sonstigen Steuerssystem zuzuführen.

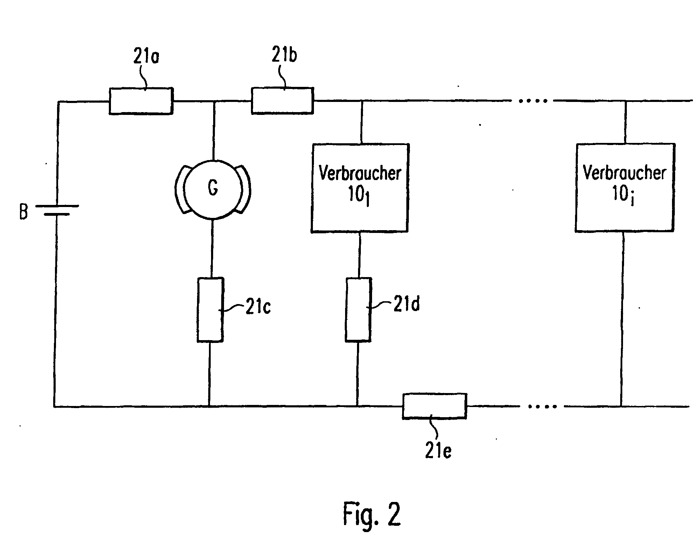

Während in Fig. 1 nur ein einziges Strommessmodul 20 vorgesehen ist, kann es in vielen Fällen zweckmäßig sein, je ein solches Modul an verschiedenen Stellen des Stromversorgungssystems in das Leistungsbussystem einzusetzen. Einige Möglichkeiten hierfür sind in Fig. 2 dargestellt, in der eine Batterie B, ein Generator G (der auch als Anlassermotor dienen kann), beliebige Verbraucher 10₁...10ᵢ und fünf an verschiedenen Stellen angeordnete Messwiderstände 21a bis 21e dargestellt sind. Darstellungsgemäß mißt der Widerstand 21a den Batteriestrom, der Widerstand 21b den Gesamtverbraucherstrom, der Widerstand 21c den Generatorstrom, der Widerstand 21d den individuellen Strom des Verbrauchers 10₁ und der Widerstand 21e den Strom einer restlichen Gruppe von Verbrauchern.

Wie eingangs schon erwähnt wurde, können mit einem in den Leistungsbus geschalteten Widerstand wie z. B. 21a die Lade- und Entladeströme der Batterie überwacht und die über den zugehörigen Steuerbus (in Fig. 2 nicht dargestellt) übertragenen entsprechenden Messsignale bzw. daraus gewonnene Steuerdaten dazu verwendet werden, den Strom auf einen für die Batterie zulässigen Maximalwert zu begrenzen. Eine ähnliche Möglichkeit besteht darin, mit aus den Messsignalen gewonnenen Steuerdaten ein Überladen oder zu starkes Entladen der Batterie zu verhindern.

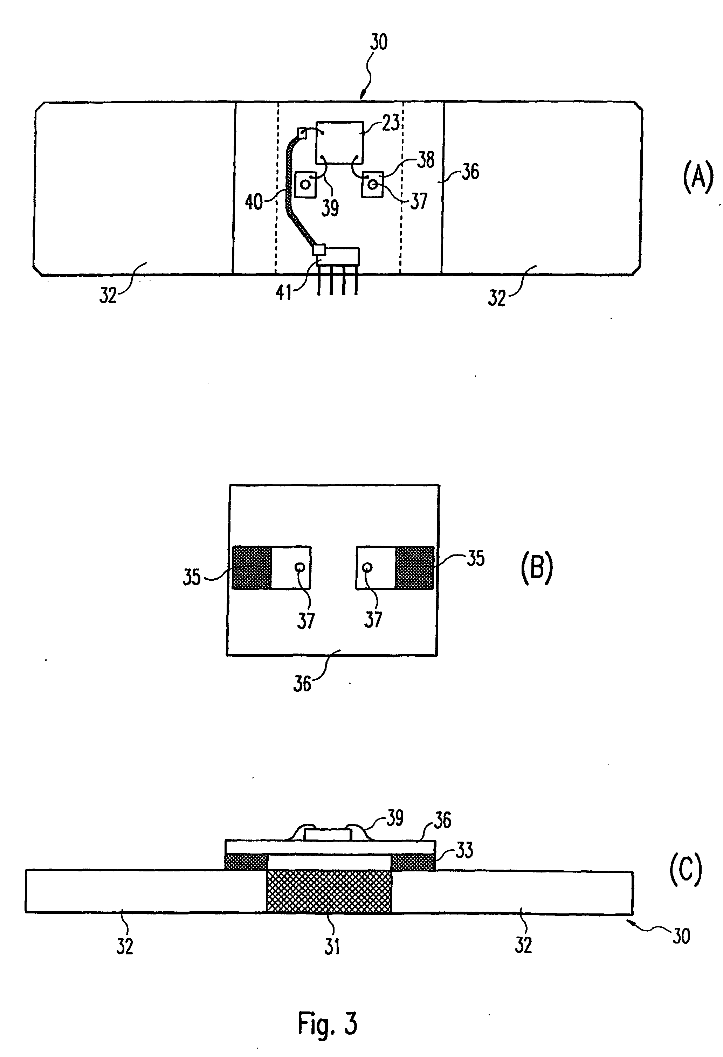

Eine erste zweckmäßige Bauform eines insbesondere (aber nicht ausschließlich) für den hier betrachteten Zweck geeigneten Strommeßmoduls mit dem Messwiderstand 21 (hier mit 30 bezeichnet) ist in Fig. 3 dargestellt, wobei Fig. 3A die Oberseite des Moduls, Fig. 3B die Unterseite einer Leiterplatte des Moduls und Fig. 3C eine Seitenansicht zeigen, jeweils ohne ein die Bestandteile des Moduls einkapselndes Gehäuse.

Der in Fig. 3A von oben und in Fig. 3C von der Seite gesehene Widerstand 30 ist insgesamt plattenförmig und in bekannter Weise aus einem Widerstandselement 31 aus einer metallischen Legierung vorzugsweise auf Kupferbasis gebildet, beispielsweise auf Basis CuMnNi wie namentlich CuMn12Ni, an dessen einander gegenüberliegende Kanten die Kanten ebenfalls plattenförmiger Stromanschlußteile 32 vorzugsweise aus Kupfer angeschweißt sind. Die Schweißverbindung kann zweckmäßig durch Elektronenstrahlschweißen realisiert sein.

Unmittelbar angrenzend an die jeweilige Schweißnaht befinden sich auf den Oberflächen der Anschlußteile 32 Lötverbindungspads 33, mit denen zweckmäßig vergoldete oder verzinnte Lötflächen 35 (Fig. 3B) an der Unterseite einer unmittelbar über dem Widerstandselement 31 angeordneten Leiterplatte 36 verlötet sind. Bis auf die Lötflächen 35 kann die Unterseite der Leiterplatte 36 mit einem Lötstoplack bedeckt sein. Die Lötflächen 35 sind über Durchkontaktierungen 37 mit Leiterflächen 38 (Fig. 3A) auf der Oberseite der Leiterplatte verbunden. Die Leiterplatte kann in bekannter Weise aus einem wärmeleitenden Isoliermaterial bestehen.

Etwa in der Mitte zwischen den seitlichen Rändern der Leiterplatte 36 und somit auch in bzw. über dem Zentrum des Widerstandselements 31 ist auf der Oberseite der Leiterplatte 36 beispielsweise mit einer wärmeleitenden Klebefolie ein Halbleiterchip 23 montiert, das über Bonddrähte 39 mit den Leiterflächen 38 und somit dem Widerstand 30 elektrisch verbundene Anschlüsse hat. Aufgrund der beschriebenen Anordnung und Verbindungen wird also dem Halbleiter die direkt an den Übergangsstellen zwischen dem Widerstandselement 31 und seinen Kupfer-Stromanschlussteilen 32 abgegriffene Spannung zugeführt, die entsprechend der üblichen 4-Leiter-Messung durch den durch die Stromanschlußteile und das Widerstandselement 31 fließenden Strom erzeugt wird. Die dafür erforderlichen Stromanschlüsse der Anschlußteile 32 sind nicht dargestellt. Der Anschluß kann beispielsweise direkt an einem Hauptstromkabel oder über Stromschienen an einer Batterie erfolgen. Ein genereller Vorteil der beschriebenen Bauform ist aber die problemlose Anpassung der Stromanschlüsse an den jeweiligen Anwendungsfall.

Weitere Anschlüsse des Halbleiterchips 23 sind über Leiterbahnen 40 der Leiterplatte 36 mit einem Stecker 41 verbunden, der z.B. zwei Stifte für die Messdatenübertragung und zwei weitere Stifte für die Spannungsversorgung des Halbleiterchips 23 haben und zur Verbindung mit dem genormten Datenbus CAN ausgebildet sein kann. Durch diese Verbindung kann die Messspannung des Widerstands auf den Massepol des Datenbus CAN bezogen sein. Der Stecker 41 kann wie das Halbleiterchip 23 auf die Leiterplatte 36 geklebt sein.

Das beschriebene Strommessmodul zeichnet sich aus durch kleines Bauvolumen, minimale Störspannungen aufgrund extrem kurzer Verbindungsleitungen, optimale Temperaturkompensationsmöglichkeit sowie die Möglichkeit sehr geringen Gesamtwiderstands und entsprechend geringer Verlustleistung und kann mit wenig Aufwand und entsprechend kostengünstig hergestellt werden. Zur Herstellung der in Fig. 3 dargestellten Bauform kann zunächst die Leiterplatte 36 vollständig vorgefertigt und mit allen Komponenten bestückt werden. Hierbei ist alternativ zu der elektrischen Verbindung des Halbleiters mit der Leiterplatte 36 durch Bonddrähte 39 auch eine sogenannte BGA-Ausführung (Ball-Grid-Array) möglich, bei der die Kontaktierung durch ein Reflow-Lötverfahren bewirkt wird. Anschließend wird die Leiterplatte 36 zweckmäßig im Reflow-Verfahren mit dem Widerstand 30 verlötet, wobei die vorverzinnten oder vergoldeten Lötflächen an der Unterseite der Leiterplatte mit den Kupferflächen des Widerstands verbunden werden, so dass sich die in Fig. 3C dargestellte Anordnung ergibt.

Der gesamte Bereich um das aktive Widerstandselement 31 mit dem darauf befindlichen Halbleiterchip 23 und dem Stecker 41 und ggf. der Leiterplatte 36 kann nach der Montage zur Bildung eines Gehäuses mit einem Kunststoff, z.B. Duroplast umhüllt werden, so dass sich ein kompaktes, mechanisch stabiles Bauteil mit zwei Stromanschlüssen an den freistehenden Anschlußteilen 32 und dem Stecker 41 ergibt.

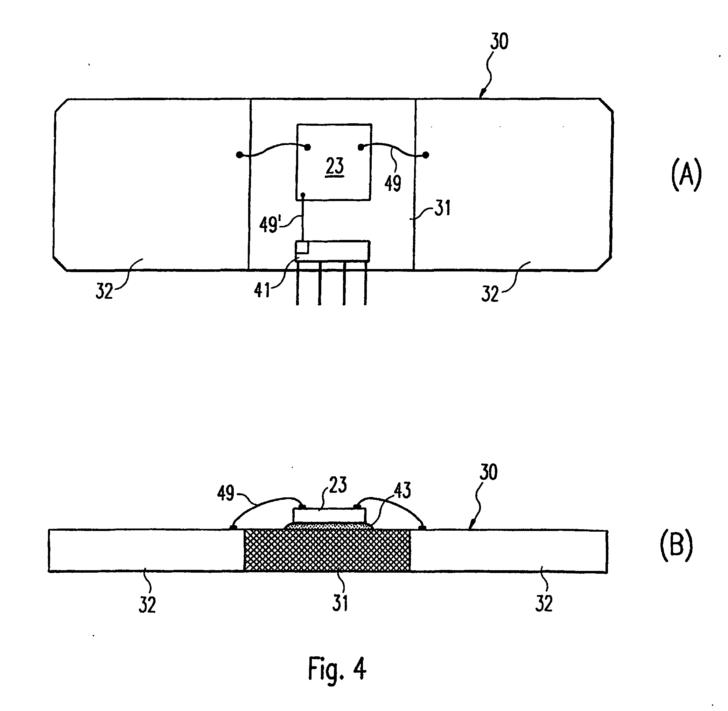

In Fig. 4 ist eine andere bevorzugte Ausführungsform des Strommessmoduls dargestellt, wobei Fig. 4A eine Draufsicht von oben und Fig. 4B eine Seitenansicht zeigen, jeweils wieder ohne Gehäuse oder Einkapselung. Das Modul kann denselben Widerstand 30 und dasselbe Halbleiterchip 23 enthalten und ebenfalls beispielsweise mit einem CAN-Stecker 41 versehen sein, wie die Ausführungsform nach Fig. 3. Das Halbleiterchip 23 ist hier aber mit einem elektrisch isolierenden, thermisch dagegen gut leitenden Kleber 43, beispielsweise einer Klebefolie, unmittelbar auf die metallische Oberfläche des Widerstandselement 31 geklebt, darstellungsgemäß etwa in die Mitte der ersichtlich größeren Widerstandsfläche. Auch der Stecker 41 ist hier auf den Widerstand geklebt. Bonddrähte 49 bzw. 49' bilden die elektrischen Verbindungen des Halbleiterchips 23 mit den Stromanschlussteilen 32, vorzugsweise wieder in unmittelbarer Nähe der Übergangsstellen zwischen Legierung und Kupfer, bzw. mit dem Stecker 41. Ein Vorteil dieser Ausführungsform ist die besonders gute thermische Kopplung zwischen Halbleiter und Widerstand und der besonders geringe und kostengünstige Herstellungsaufwand.

Das Halbleiterchip 23 kann als ASIC (application - specific integrated circuit) auf kleinstem Raum (wenige mm Chipkantenlänge) u.a. die gesamte zur Strommessung erforderliche Auswerteund Signalübertragungselektronik mit Verstärkerschaltung, A/D-Wandler und Mikroprozessor enthalten. Darüber hinaus enthält es einen speziellen, in an sich bekannter Weise als Halbleiterelement (Transistor) gebildeten Temperatursensor, der aufgrund der beschriebenen Wärmekopplung permanent die Temperatur des Widerstandselements 31 mißt, und aus dessen Messinformation beispielsweise der vorhandene, hier als Temperaturkompensationsschaltung dienende Prozessor Korrekturdaten für die Strommesssignale errechnet. Durch diese Kompensation des an sich geringen Einflusses des Temperaturkoeffizienten (TK) des Widerstands wird höchstmögliche Messgenauigkeit des aufgrund seines Legierungstyps ohnehin sehr präzisen Widerstands erreicht.

Das Halbleiterchip 23 kann ferner einen besonderen Permanentspeicher beispielsweise vom Typ EEPROM enthalten, der für die Kalibrierung des Messwiderstands verwendet wird. Hierbei wird zunächst nach der Herstellung des Widerstands 30 dessen tatsächlicher Wert ggf. temperaturabhängig gemessen und digital gespeichert. Später wird dann nach der Montage des Widerstands im Strommessmodul und eventuell erst nach dessen Einbau in das Stromversorgungssystem z.B. gemäß Fig. 1 der tatsächliche Widerstandswert als Kalibrierungsdaten zweckmäßig über den Steuerbus CAN in das Halbleiterchip 23 übertragen und dort permanent gespeichert. Mit den gespeicherten Kalibrierungsdaten wird beim Stromüberwachungsbetrieb kontinuierlich die an den Widerstand angeschlossene Messschaltung zur Erzeugung korrigierter Messdaten gesteuert. Der sonst bei Messwiderständen erforderliche Kalibrierungsaufwand entfällt.

Ein praktisch realisiertes Strommessmodul der beschriebenen Art mit einem Widerstandswert in der Größenordnung von 0,1-0,5 mOhm ist in der Lage, kurzfristige Ströme bis 500 A und Dauerströme bis 200 A zu messen. Die Messauflösung kann 14 bis 16 bit betragen, die Messrate > 1kHz entsprechend einer Messzeit < 1msec. Das Strommessmodul ist im gesamten Versorgungsspannungsbereich einsetzbar und problemlos in vorhandene Steuermodule etwa eines Kraftfahrzeugs wie z.B. Regler und Sicherheitsabschalter integrierbar.

## Patentansprüche

1. Verfahren zur automatischen Stromüberwachung in einem elektronisch gesteuerten Stromversorgungssystem für mehrere Verbraucher (10, 11, 12), die über einen ihnen gemeinsamen Leistungsbus (LB) mit Strom versorgt und über einen mehrere elektronische Steuereinheiten (µC1, µC2...µCn) untereinander und mit den Verbrauchern verbindenden Steuerbus (CAN) für digitale Informations- und Steuerdaten gesteuert werden, wobei der Verbraucherstrom von einem Messwiderstand (21) gemessen wird, der dem Strom entsprechende Messsignale erzeugt, die über den Steuerbus (CAN) einer permanent mit dem Messwiderstand verbundenen elektronischen Steuer- und Überwachungseinrichtung zugeführt werden, insbesondere zur Überwachung des Stroms der Verbraucher in einem Fahrzeug,
wobei,
von dem in den Leistungsbus (LB) geschalteten Messwiderstand (21) der Gesamtstrom mehrerer an den Leistungsbus angeschlossener Verbraucher (10, 11, 12) gemessen wird, um dem gemessenen Gesamtstrom entsprechende Messsignale zu erzeugen, und wobei
aus den Strommesssignalen dieses Widerstands (21) gewonnene Steuerdaten dem Steuerbus (CAN) zugeführt werden, und wobei die elektronische Steuer- und Überwachungseinrichtung beim Schalten eines der Verbraucher die Differenz der von dem Messwiderstand (21) vor und nach dem Schalten gemessenen Werte des zu den Verbrauchern fließenden Gesamtstroms auswertet.

2. Verfahren nach Anspruch 1, **dadurch gekennzeichnet, dass** als Messwiderstand (21) ein aus einer Kupferlegierung bestehendes Widerstandselement (31) verwendet wird.

3. Verfahren nach Anspruch 1 oder 2, **dadurch gekennzeichnet, dass** die elektronische Steuer- und Überwachungseinrichtung zur Auswertung der Stromdifferenz diese mit einem gespeicherten Sollwert oder Sollwertbereich vergleicht und bei unnormaler Abweichung ein Warnsignal erzeugt.

4. Verfahren nach einem der Ansprüche 1 bis 3, **dadurch gekennzeichnet, dass** von dem in den Leistungsbus (LB) geschalteten Messwiderstand (21) die Lade- und/oder Entladeströme einer den Leistungsbus (LB) speisenden Batterie (B) gemessen und den gemessenen Batteriestromwerten entsprechende Strommessdaten dem Steuerbus (CAN) zugeführt werden, und dass die Steuer- und Überwachungseinrichtung aufgrund dieser Strommessdaten Schaltsignale zur Begrenzung des Batteriestroms auf einen vorgegebenen zulässigen Maximalwert erzeugt.

5. Verfahren nach einem der Ansprüche 1, 3 oder 4, **dadurch gekennzeichnet, dass** als Messwiderstand (21) ein metallischer Messwiderstand verwendet wird, dessen Stromanschlüsse elektrisch seriell in den Leistungsbus (LB) geschaltet werden und dessen an seinen Spannungsanschlüssen erzeugte analoge Messspannung von einem mit dem Widerstand zu einem Strommessmodul (20) in einem gemeinsamen Gehäuse zusammengebauten Halbleiterchip (23) in digitale Messsignale umgewandelt werden, die dem Steuerbus (CAN) zugeführt werden.

6. Verfahren nach Anspruch 5, **dadurch gekennzeichnet,**
**dass** der Messwiderstand (21) durch ein plattenförmiges Element (31) aus einer Widerstandslegierung gebildet wird, an dessen Kanten plattenförmige Stromanschlussteile (32) angeschweißt sind.

7. Verfahren nach einem der vorhergehenden Ansprüche,
**dadurch gekennzeichnet,**
**dass** der Messwiderstand (21) durch externe digitale Daten kalibriert wird, die durch Messen seines tatsächlichen Widerstandswertes gewonnen und in einem mit dem Widerstand verbundenen Halbleiterspeicher gespeichert werden und beim Stromüberwachungsbetrieb eine an den Widerstand angeschlossene Messschaltung zur Erzeugung korrigierter Messdaten steuern.

8. Verfahren nach Anspruch 7, **dadurch gekennzeichnet,**
**dass** die externen Kalibrierungsdaten dem Halbleiterspeicher über den Steuerbus (CAN) zugeführt werden.

9. Einrichtung zur automatischen Stromüberwachung in einem elektronisch gesteuerten Stromversorgungssystem für mehrere Verbraucher (10, 11, 12), die über einen ihnen gemeinsamen Leistungsbus (LB) mit Strom versorgt werden,
mit einem Steuerbus (CAN) für digitale Informations- und Steuerdaten, der mehrere elektronische Steuereinheiten (µC1, µC2...µCn) untereinander und mit den Verbrauchern verbindet,
mit einem Messwiderstand (21), der dem Verbraucherstrom entsprechende Messsignale erzeugt,
und mit einer über den Steuerbus (CAN) permanent mit dem Messwiderstand (21) verbundenen elektronischen Steuer- und Überwachungseinrichtung,
insbesondere zur Überwachung des Stroms der Verbraucher in einem Fahrzeug,
wobei,
der Messwiderstand (21) in dem Leistungsbus (LB) mehreren an den Leistungsbus angeschlossenen Verbrauchern (10, 11, 12) vorgeschaltet ist und den zu den Verbrauchern fließenden Gesamtstrom und/oder die Lade- oder Entladeströme einer den Leistungsbus (LB) speisenden Batterie (B) misst und entsprechende Messsignale erzeugt, und wobei
die Gesamtstrommesssignale oder daraus gewonnene Steuerdaten dem Steuerbus (CAN) zugeführt werden
und wobei die elektronische Steuer- und Überwachungseinrichtung beim Schalten eines der Verbraucher (10, 11, 12) die Differenz der von dem Messwiderstand (21) vor und nach dem Schalten gemessenen Werte des zu den Verbrauchern fließenden Gesamtstroms auswertet und/oder wobei aufgrund des gemessenen Batteriestroms Schaltsignale zur Begrenzung des Batteriestroms auf einen vorgegebenen zulässigen Maximalwert erzeugt.

10. Einrichtung nach Anspruch 9, **dadurch gekennzeichnet, dass** das Widerstandselement (31) des Messwiderstands (21) aus einer Kupferlegierung besteht.

11. Einrichtung nach Anspruch 9 mit einem elektrisch mit den Spannungsanschlüssen des Messwiderstands (21, 30) verbundenen Halbleiterbauelement (23), das eine Messschaltung zur Erzeugung von digitalen Strommesssignalen enthält,
**dadurch gekennzeichnet,**
**dass** der Messwiderstand (21, 30) aus einem aus einer Metalllegierung bestehenden Widerstandselement (31) gebildet ist und das Halbleiterbauelement (23) mit wärmeleitender Verbindung auf einer ebenen Oberfläche des Widerstandselements (31) und/oder seiner Stromanschlussteile (32) angeordnet ist.

12. Einrichtung nach Anspruch 11, **dadurch gekennzeichnet,**
**dass** das Halbleiterbauelement (23) einen Temperatursensor enthält, und dass eine in dem Halbleiterbauelement (23) vorgesehene Temperaturkompensationsschaltung die Strommesssignale in Abhängigkeit von der mit dem Temperatursensor gemessenen Temperatur des Widerstandselements (31) korrigiert.

13. Einrichtung nach Anspruch 11 oder 12, **dadurch gekennzeichnet, dass** das Halbleiterbauelement (23) auf der einen Hauptoberfläche des aus einer Metalllegierung bestehenden, plattenförmigen ausgebildeten Widerstandselements (31) angeordnet ist, an dessen einander gegenüberliegende Kanten plattenförmige Stromanschlussteile (32) angeschweißt sind.

14. Einrichtung nach einem der Ansprüche 11 bis 13,
**dadurch gekennzeichnet, dass** das Halbleiterbauelement (23) unmittelbar auf die Metalloberfläche des Widerstandselements (31) geklebt und mit dessen Stromanschlussteilen (32) durch Bonddrähte (49) verbunden ist.

15. Einrichtung nach einem der Ansprüche 11 bis 13,
**dadurch gekennzeichnet, dass** das Halbleiterbauelement (23) auf der einen Seite einer Leiterplatte (36) montiert ist, die auf ihrer entgegengesetzten Seite auf der Metalloberfläche des Messwiderstands (21, 30) angeordnet und mit dessen Stromanschlussteilen (32) verlötet ist.

16. Einrichtung nach einem der Ansprüche 11 bis 15, **dadurch gekennzeichnet, dass** das Halbleiterbauelement (23) einen A/D-Wandler, eine Verstärkerschaltung und/oder einen Mikroprozessor für die Meßsignale des Messwiderstands (21, 30) enthält.

17. Einrichtung nach einem der Ansprüche 11 bis 16,
**dadurch gekennzeichnet, dass** ein Steckverbinder (41) zum Anschluss des Halbleiterbauelements (23) an den Steuerbus (CAN) vorgesehen ist.

18. Einrichtung nach Anspruch 17, **dadurch gekennzeichnet, dass** der Steckverbinder (41) ein auf die Metalloberfläche des Messwiderstands (21, 30) oder auf eine ggf. zwischen dem Widerstand (30) und dem Halbleiterbauelement (23) angeordnete Leiterplatte (36) geklebtes, elektrisch mit dem Halbleiterbauelement (23) verbundenes Bauteil ist.

## Claims

1. Method of automatic current monitoring in an electronically controlled current supply system for a plurality of loads (10, 11, 12) which are supplied with current via a power bus (LB) which is common to them and via a control bus (CAN) for digital information and control data which connects a plurality of electronic control units (µC1, µC2... µCn) to one another and to the loads, wherein the load current is measured by a measuring resistor (21) which generates measurement signals corresponding to the current which are supplied via the control bus (CAN) to an electronic control and monitoring device which is permanently connected to the measuring resistor, particularly for monitoring the current of the load in a motor vehicle, wherein the total current of a plurality of loads (10, 11, 12) connected to the power bus is measured by the measuring resistor connected into the power bus (LB) in order to generate measurement signals corresponding to the measured total current, and wherein control data obtained from the current measurement signals of this resistor (21) are supplied to the control bus (CAN), and wherein during switching of one of the loads the electronic control and monitoring device evaluates the difference between the values of the total current flowing to the loads measured by the measuring resistor (21) before and after the switching.

2. Method as claimed in Claim 1, **characterised in that** a resistor element (31) made from a copper alloy is used as the measuring resistor (21).

3. Method as claimed in Claim 1 or 2, **characterised in that** the electronic control and monitoring device for evaluation of the current difference compares this current difference with a stored desired value or desired value range and generates a warning signal in the event of abnormal deviation.

4. Method as claimed in one of Claims 1 to 3, **characterised in that** the charging and/or discharging currents of a battery (B) supplying the power bus (LB) is measured by the measuring resistor (21) connected into the power bus (LB) and current measurement data corresponding to the measured battery current values are delivered to the control bus (CAN), and that on the basis of these current measurement data the control and monitoring device generates switching signals for limitation of the battery current to a predetermined permissible maximum value.

5. Method as claimed in one of Claims 1, 3 or 4, **characterised in that** a metal measuring resistor is used as the measuring resistor (21), wherein the current connections thereof are electrically connected in series into the power bus (LB) and the analogue measurement voltage thereof which is generated at the voltage connections thereof is converted by a semiconductor chip (23), which is combined with the resistor in a common housing to form a current measurement module (20), into digital measurement signals which are delivered to the control bus (CAN).

6. Method as claimed in Claim 5, **characterised in that** the measuring resistor (21) is formed by a plate-shaped resistor element (31) made from a resistor alloy, plate-shaped current connection parts (32) being welded onto the edges of the said resistor element.

7. Method as claimed in one of the preceding claims, **characterised in that** the measuring resistor (21) is calibrated by external digital data which are obtained by measuring the actual resistance value thereof and are stored in a semiconductor memory connected to the resistor and which during current monitoring operation control a measuring circuit connected to the resistor in order to generate corrected measurement data.

8. Method as claimed in Claim 7, **characterised in that** the external calibration data are delivered to the semiconductor memory via the control bus (CAN).

9. Device for automatic current monitoring in an electronically controlled current supply system for a plurality of loads (10, 11, 12) which are supplied with current via a power bus (LB) which is common to them, with a control bus (CAN) for digital information and control data which connects a plurality of electronic control units (µC1, µC2... µCn) to one another and to the loads, with a measuring resistor (21) which generates measurement signals corresponding to the load current, and with an electronic control and monitoring device which is permanently connected to the measuring resistor (21) via the control bus (CAN), particularly for monitoring the current of the load in a motor vehicle, wherein the measuring resistor (21) is connected in the power bus (LB) before a plurality of loads (10, 11, 12) connected to the power bus and measures the total current flowing to the loads and/or the charging or discharging currents of a battery (B) supplying the power bus (L) and generates corresponding measurement signals, and wherein the total current measurement signals control data obtained therefrom are supplied to the control bus (CAN), and wherein during switching of one of the loads (10, 11, 12) the electronic control and monitoring device evaluates the difference between the values of the total current flowing to the loads measured by the measuring resistor (21) before and after the switching and/or on the basis of the measured battery current generates switching signals for limitation of the battery current to a predetermined permissible maximum value.

10. Device as claimed in Claim 9, **characterised in that** the resistor element (31) of the measuring resistor (21) is made from a copper alloy.

11. Device as claimed in Claim 9 with a semiconductor component (23) which is electrically connected to the voltage connections of the measuring resistor (21, 30) and contains a measuring circuit to generate digital current measurement signals, **characterised in that** the measuring resistor (21, 30) is formed from a resistor element (31) made from a metal alloy and the semiconductor component (23) is disposed with heat-conducting connection on a level surface of the resistor element (31) and/or the current connection parts (32) thereof.

12. Device as claimed in Claim 11, **characterised in that** the semiconductor component (23) contains a temperature sensor and that a temperature compensation circuit provided in the semiconductor component (23) corrects the current measurement signals as a function of the temperature of the resistor element (31) measured by the temperature sensor.

13. Device as claimed in Claim 11 or 12, **characterised in that** the semiconductor component (23) is disposed on one main surface of the resistor element (31) of plate-shaped construction made from a metal alloy, plate-shaped current connection parts (32) being welded onto the edges thereof which lie opposite one another.

14. Device as claimed in one of Claims 11 to 13, **characterised in that** the semiconductor component (23) is adhered directly onto the metal surface of the resistor element (31) and is connected to the current connection parts (32) thereof by bonding wires (49).

15. Device as claimed in one of Claims 11 to 13, **characterised in that** the semiconductor component (23) is mounted on one side of a circuit board (36) which on its opposite side is disposed on the metal surface of the measuring resistor (21, 30) and is soldered to the current connection parts (32) thereof.

16. Device as claimed in one of Claims 11 to 15, **characterised in that** the semiconductor component (23) contains a A/D converter, an amplifier circuit and/or a microprocessor for the measurement signals of the measuring resistor (21, 30).

17. Device as claimed in one of Claims 11 to 16, **characterised in that** a plug-type connector (41) is provided for connection of the semiconductor component (23) to the control bus (CAN).

18. Device as claimed in Claim 17, **characterised in that** the plug-type connector (41) is a component which is electrically connected to the semiconductor component (23) and is adhered to the metal surface of the measuring resistor (30) or to a circuit board (36) disposed optionally between the resistor (30) and the semiconductor component (23).

## Revendications

1. Procédé de surveillance automatique du courant dans un système d'alimentation en courant commandé électroniquement pour plusieurs récepteurs (10, 11, 12), qui sont alimentés en courant par un bus d'alimentation (LB) qui leur est commun, et sont commandés au moyen d'un bus de commande (CAN) reliant plusieurs unités électroniques de commande (µC1, µC2... µCn) entre elles ainsi qu'avec les récepteurs, pour des données numériques de commande et d'information, le courant des récepteurs étant mesuré par une résistance de mesure (21) qui génère des signaux de mesure représentatifs du courant, qui sont amenés, par le bus de commande (CAN), à un dispositif de commande et de surveillance relié en permanence à la résistance de mesure, notamment pour la surveillance du courant des récepteurs dans un véhicule, le courant total de plusieurs récepteurs (10, 11, 12) reliés au bus d'alimentation (LB) étant mesuré par la résistance de mesure (21) et les données de commande dérivées des signaux de courant de cette résistance étant amenés au bus de commande (CAN) et le dispositif électronique de commande et de surveillance exploitant, lors du branchement de l'un des récepteurs, la différence des valeurs mesurées, avant et après le branchement, par la résistance de mesure (21) du courant total s'écoulant vers les récepteurs.

2. Procédé selon la revendication 1, **caractérisé en ce que** l'on utilise comme résistance de mesure (21) un élément de résistance (31) en alliage de cuivre.

3. Procédé selon la revendication 1 ou 2, **caractérisé en ce que** le dispositif électronique de commande et de surveillance, pour l'évaluation de la différence de courant, compare celle-ci avec une valeur prescrite ou une plage de valeurs prescrites mémorisée, et génère un signal d'alarme lorsqu'il y a un écart anormal.

4. Procédé selon les revendications 1 à 3, **caractérisé en ce que**, par la résistance de mesure (21) montée par le bus d'alimentation, les courants de charge et/ou de décharge d'une batrerie (B), alimentant le bus d'alimentation (LB), sont mesurés et les données de courant correspondant aux valeurs des courants de batterie sont envoyés au bus de commande (CAN), et **en ce que** le dispositif électronique de commande et de surveillance génère des signaux de commutation pour limiter le courant de batterie à une valeur maximale acceptable prédéterminée, en fonction de ces données de courant.

5. Procédé selon l'une des revendications 1, 3 ou 4, **caractérisé en ce que** l'on utilise comme résistance de mesure (21) une résistance de mesure métallique dont les bornes sont motées en série dans le bus d'alimentation et dont la tension de mesure analogique générée à ses bornes est convertie, par une puce à semi-conducteurs (23) montée conjointement avec la résistance dans un boîtier commun en un module de courant (20), en signaux numériques qui qont envoyés au bus de commande (CAN).

6. Procédé selon la revendication 5, **caractérisé en ce que** la résistance de mesure (21) est formée par élément en forme de plaque (31) en un aliage résistant, aux bords de laquelle des parties de branchement de courant en forme de plaque (32) sont soudées.

7. Procédé selon l'une des revendications précédentes, **caractérisé en ce que** la résistance de mesure (21) est calibrée avec des données numériques extrnes obtenues en mesurant sa valeur réelle et mémorisées dans une mémoiire à semi-conducteur reliée à la résistanceet commanden , en fonction de surveillance de courant, un circuit de mesure relié à la résistance pour générer des données de mesure corrigées.

8. Procédé selon la revendication 7, **caractérisé en ce que** les données externes de calibrage sont envoyées à la mémoire à semi-conducteur par le bus de commande (CAN).

9. Dispositif de surveillance automatique du courant dans un système d'alimentation en courant commandé électroniquement pour plusieurs récepteurs (10, 11, 12), qui sont alimentés en courant par un bus d'alimentation (LB) qui leur est commun,
avec un bus de commande (CAN) reliant plusieurs unités électroniques de commande (µC1, µC2... µCn) entre elles ainsi qu'avec les récepteurs, pour des données numériques de commande et d'information
une résistance de mesure (21) qui génère des signaux de mesure représentatifs du courant du récepteur,
et un dispositif électronique de commande et de surveillance relié en permanence à la résistance de mesure (21) par le bus de commande (CAN),
notamment pour la surveillance du courant des récepteurs dans un véhicule
la résistance de mesure étant montée dans le bus d'alimentation (LB) en amont de de plusieurs récepteurs (10, 11, 12) reliés au bus d'alimentation et mesurant le courant total circulant vers les récepteurs et/ ou le courant de charge ou de décharge d'une batterie (B) alimentant le bus d'alimentation (LB) et générant des signaux de mesure correspondants, les signaux de courant total ou les données issues de ces derniers étant envoyées au bus de commande (CAN),
et le dispositif électronique de commande et de surveillanceexploitant, lors du branchement de l'un des récepteurs (10, 11, 12) , la différence des valeurs mesurées, avant et après le branchement, par la résistance de mesure (21) du courant total s'écoulant vers les récepteurs et/ou, en réponse au courant de batterie mesuré, génère des signaux de commutation pour limiter le courant de la batterie à une valeur maximale acceptable prédéterminée.

10. Dispositif selon la revendication 9, **caractérisé en ce que** l'élément de résistance (31) de la résistance de mesure (21) est en alliage de cuivre.

11. Dispositif selon la revendication 9, avec un composant à semi-conducteurs (23) relié électriquement aux bornes de connexion de tension de la résistance de mesure (21, 30), comportant un circuit de mesure pour générer des signaux numériques de courant, **caractérisé en ce que**
la résistance de mesure (21, 30) est constituée par un élément de résistance (31) en alliage métallique et le composant à semi-conducteurs (23) est disposé, avec une liaison conduisant la chaleur sur une surface supérieure plane de l'élément de résistance (31) et/ou sur ses parties de branchement de courant (32).

12. Dispositif selon la revendication 11, **caractérisé en ce que** le composant à semi-conducteurs (23) comporte une sonde de température et **en ce qu'**un circuit de compensation de température contenu dans le composant à semi-conducteurs (23) corrige les signaux de courant en fonction de la température mesurée par la sonde de température de l'élément de résistance (31).

13. Dispositif selon la revendication 11 ou 12, **caractérisé en ce que** le composant à semi-conducteurs (23) est monté sur l'une des faces principales de l'élément de résistance (31) en alliage métallique et en forme de plaque aux bords opposés duquel sont soudées des pièces de branchement de courant (32) en forme de plaquette.

14. Dispositif selon l'une des revendications 11 à 13, **caractérisé en ce que** le composant à semi-conducteurs (23) est colé directement sur la face métallique de l'élément de résistance (31) et est relié à ses pièces de branchement de courrant (32) par des fils de liaison (49).

15. Dispositif selon l'une des revendications 11 à 13, **caractérisé en ce que** le composant à semi-conducteurs (23) est monté sur la face d'une plaquette de circuit intégré qui sur sa face opposée qui est disposée sur sa face opposée, sur la face métallique de la résistance de mesure (21, 30) et soudée à ses pièces de branchement de courant (32).

16. Dispositif selon l'une des revendications 11 à 15, **caractérisé en ce que** le composant à semi-conducteurs (23) comporte un convertisseur analogique/numérique, un circuit amplificateur et /ou un microprocesseur pour les signaux de mesure de la résistance de mesure (21, 30).

17. Dispositif selon l'une des revendications 11 à 16, **caractérisé en ce qu'**il est prévu un connecteur enfichable (41) pour la connexion du composant à semi-conducteurs (23) au bus de commande (CAN).

18. Dispositif selon la revendication 17, **caractérisé en ce que** le connecteur enfichable (41) est un composant collé sur la face métallique de la résistance de mesure (21, 30) ou une plaquette de circuit imprimé, disposée le cas échéant entre la résistance (30) et le composant à semi-conducteurs (23), relié électriquement au composant à semi-conducteurs (23).
